# EUROPEAN PATENT SPECIFICATION

(11) **EP 0 477 643 B1**
(45) Date of publication and mention of the grant of the patent: **05.03.1997**
(21) Application number: 91115197.5
(22) Date of filing: 09.09.1991
(51) Int. Cl.: H02M 1/08, H02P 5/22, H03K 17/725

(54) **Control of a discontinuous current by a thyristor rectifier with inductive load**
Steuerung eines diskontinuierlichen Stromes in einer induktiven Last mittels eines Thyristorgleichrichters
Commande d'un courant discontinu dans une charge inductive au moyen d'un redresseur à thyristor

(30) Priority: 28.09.1990 US 589860
(43) Date of publication of application: 01.04.1992
(73) Proprietor: OTIS ELEVATOR COMPANY, Farmington, CT 06032 (US)
(72) Inventor: Ackermann, Bernd Ludwig, W-1000 Berlin 27 (DE); Herkel, Peter Leo, W-1000 Berlin 65 (DE)
(74) Representative: Klunker . Schmitt-Nilson . Hirsch

(56) References cited:
- FR-A- 2 371 726
- US-A- 3 959 668
- US-A- 4 876 468
- PATENT ABSTRACTS OF JAPAN vol. 014, no. 218 (E-0925)9 May 1990 & JP-A-20 53 319
- PATENT ABSTRACTS OF JAPAN vol. 1, no. 80 (E-77)(1371) 27 July 1977 & JP-A-52 016 158
- APEC'90 11 March 1990, L.A. CALIFORNIA pages 668 - 671 B.FRANCOEUR & AL. 'use of gto as zero turn-off time thyristor in series resonant inverters'

## Description

This invention relates to control of the output current of a thyristor rectifier having an inductive load where that current becomes discontinuous.

The speed of a Ward Leonard type DC drive is controlled by the generator field current. Therefore, the performance of the speed control depends on the quality of the field current control. To achieve slow speed, the generator field current has to be controlled at a very low level, while during deceleration or reversal, respectively, the field current has to cross zero and change its sign.

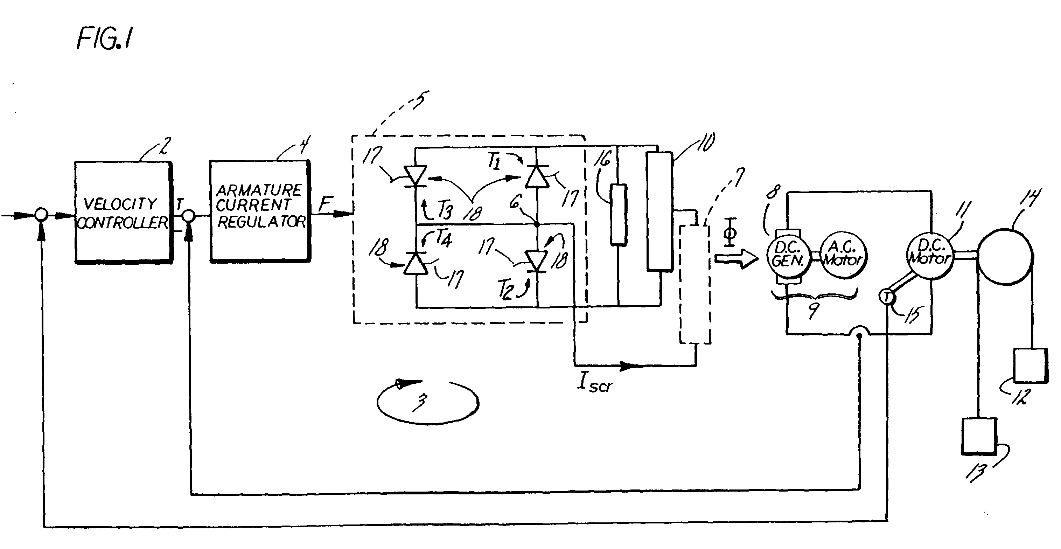

A controlled rectifier using thyristors is a cost effective type of regulating unit for the field current control. Fig. 1 shows a typical thyristor configuration, a two-way power converter, in a generator field power converter in a typical cascade drive control scheme. A velocity controller 2 compares actual velocity with a dictated velocity and sets an appropriate torque command T which is the reference input for the armature current control loop 3. An armature current regulator 4 calculates a firing angle A which activates an SCR converter 5 to set the output voltage Vgf of the generator field winding 7 of the generator 8 of the MG-set 9, thus providing a current Iscr through the generator field winding 7. The SCR converter 5 is connected to a power transformer secondary winding 10, part of a typical sinusoidal voltage source (not shown), for receiving a power signal. A DC hoist motor 11 will be activated by the generator armature voltage to produce a torque proportional to the armature current Ia, thereby moving the counterweight 12 and car 13 through rotation of the sheave 14. Actual velocity is fed back to be summed with the dictated velocity by means of a tachometer 15. A digital synchronization signal is generated by 16, in phase with the line voltage, across the power transformer secondary winding 10.

The converter 5 is a two-way power converter consisting of two center tap-connected pairs of thyristors (T1,T3) and (T2,T4) in anti-parallel connection. The thyristors (T3) and (T4) are fired to achieve a generator field current in the positive direction, causing a motor torque for the elevator traveling in the up direction, while (T1) and (T2) are fired to achieve current in the other direction, causing a motor torque while the elevator is traveling in the down direction. The thyristors for the positive half-wave of the line voltage are (T2,T3), and the thyristors for the negative half-wave of the line voltage are (T1,T4). The gates 17 of the SCRs 18 are operatively connected to the current regulator 4 which controls the conduction state of each SCR 18. The SCRs 18 are driven by pairs into conduction at various times during the cycle of the AC energy from the source and a resultant DC output voltage is produced.

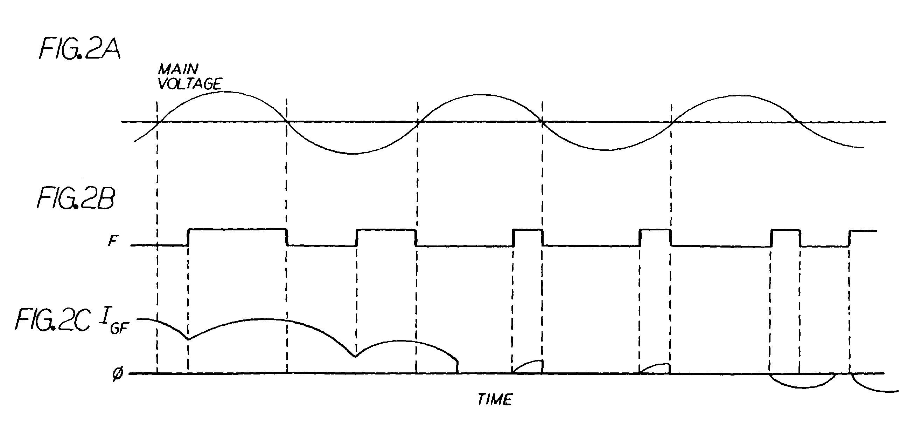

A given current can be achieved by firing the thyristors at a fixed firing angle (Fig. 2). The thyristors are fired by switching on the thyristor gate current at an instant corresponding to the firing angle. The gate current can have the shape either of a short pulse or a long pulse, that is to say, either of a slim pulse or of a square wave ending at the next zero crossing of the AC voltage or even lasting until the next thyristor is fired in the following half-wave.

If the load were resistive, Igf would become zero after the end of the half-wave of the mains voltage and stay zero until the respective thyristor is fired in the next half-wave. With an inductive load, however, the load forces Igf to continue flowing through the same thyristor and transformer winding even in the next half-wave where it then flows in a direction opposite the mains voltage until the respective thyristor is fired in that half-wave.

In case of firing angles in the range of 90 to 180 degrees electric, the generator field current becomes discontinuous if the average value is lower than a certain limit. Discontinuity means that the field current is zero within a certain period of time during each half-wave of the mains ac voltage. Discontinuity is caused by the interaction of two effects. The first is the ripple of the field current which depends on the shape of the field voltage and the values of the field inductivity and resistance. The second is the special behavior of the thyristors to switch off currents below a holding current or latching current.

When operating the thyristor rectifier with inductive load at discontinuous current, the conventional firing method explained above would be disadvantageous for the following two reasons.

First, there are two thyristor forward on-state current margins, "Latching Current" and "Holding Current", that determine the thyristor performance at discontinuous current. Their values vary between about 50 and 800 mA depending on thyristor type and several parameters such as junction temperature.

An SCR requires a certain minimum anode current to maintain it in the closed, or conducting, state. If, while the gate current is zero, the anode current drops below this minimum level designated as the holding current, the SCR reverts to the forward blocking, or open state. The holding current has a negative temperature coefficient, that is to say, as SCR junction temperature drops, its holding current requirement increases. A somewhat higher value of anode current than the holding current is required for the SCR to initially pick up. If this higher value of anode latching current is not reached, the SCR will revert to the blocking state as soon as the gate signal is removed. After this initial pickup action, however, the anode may be reduced to the holding current level.

For the SCR to trigger, the anode current must be allowed to build up rapidly enough so that the latching current is reached before the triggering pulse is terminated. For highly inductive anode circuits, one must use a maintained trigger which assures gate drive until latching current has been attained. Fig. 2a shows the line voltage. Fig. 2b shows the thyristor gate current. Fig. 2c shows the latching and holding currents and the resulting generator field current. With a high firing angle, the generator field current becomes discontinuous. Increases in firing angle bring increases in the time of current discontinuity.

If the thyristor current does not reach the "Latching Current" before the gate current ends, the thyristor switches off at the end of the gate current. If the thyristor current falls below the "Holding Current" after the gate current has ended, the thyristor switches off at once.

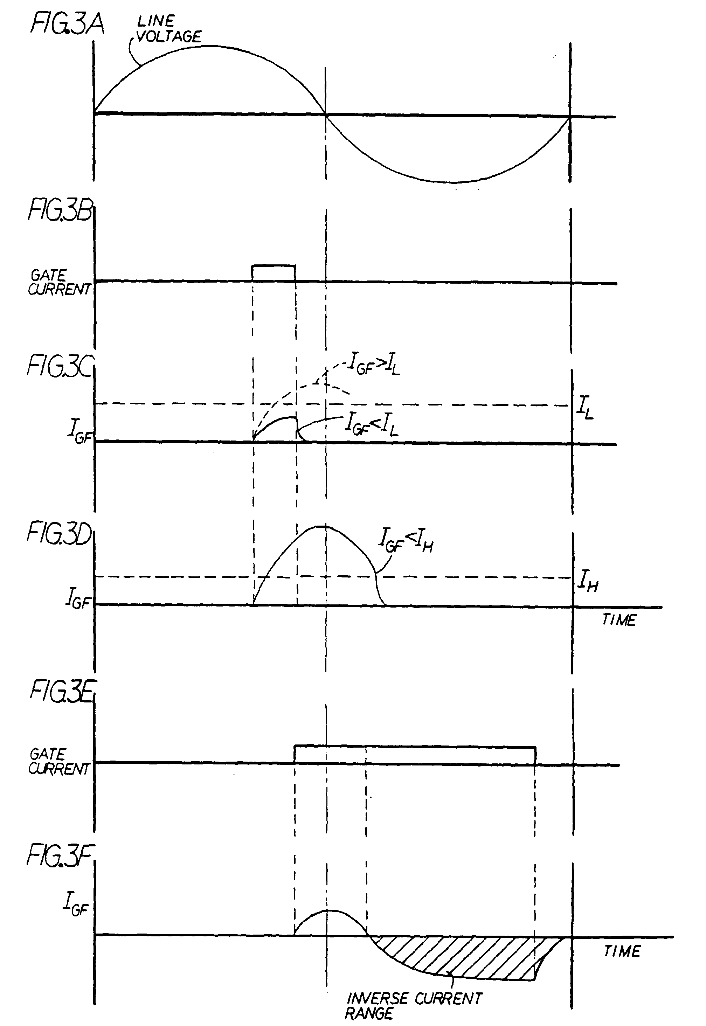

The thyristor forward on-state current is equal to the field current. So, if the field current remains or falls below one of these margins, it is switched off by the thyristor. As this effect can vary from period to period due to the parameters mentioned above, no stable status can be achieved. In a closed loop control system, this effect, when coupled with the effects of control loop time constants, results in oscillations of the generator field current and therefore the drive movement as well. Fig. 3a shows the line voltage, Fig. 3b shows the gate voltage waveform and Figs. 3c and 3d show the effects upon generator field current where the gate period is too short. In Fig. 3c, the generator field current begins to climb with the application of the gate voltage and will be maintained if the thyristor current achieves the latching current before the gate voltage is taken away. However, if the latching current is not achieved before the gate voltage is gone, the generator field current begins to decay back to zero (Fig. 3c). Fig. 3c shows the generator field current turning off suddenly when the generator field current drops below the holding current.

The second reason the above firing method would be disadvantageous is that if the gate current continues flowing even after the thyristor current has become zero and the thyristor is stressed by a reverse off-state voltage, a considerable reverse thyristor current will flow, causing heat losses. Furthermore, if the thyristor is fired late enough within the half-wave, the average reverse current will be bigger than the forward current, resulting in an average negative generator field current.

This effect is especially troublesome when the field current is reversed by switching the control over to the second part of the rectifier, being a part of the two-way converter, which is connected with inverse polarity. In this case, the field current would be increased in the previous direction again to an average value determined by the reverse current of the thyristors of that second part of the rectifier. This results in a torque transient and causes vibrations in the drive.

Figs. 3e and 3f show the generator field current when the gate signal continues to flow far into the negative half-wave after the positive thyristor current has long since ended. The result is inverse generator field current.

From document JP-A-2,053,319 a trigger method for thyristor elements has become known. A gate pulse is generated, based on a first condition that a thyristor current of a first phase X is as high as a first reference value, and on a second condition that a thyristor current of a second phase reaches or exceeds a second reference value. Document D1 further discloses a thyristor rectifier circuit controlling an AC current through an inductive load using a pair of thyristors in reverse parallel connection. Only the case of full angle control is considered in said document, and it is the aim to avoid discontinuity of the current by gating the thyristors in time. This is done by gating the thyristors a bit too early. So the thyristor for the negative current half wave is already gated when still a small positive current is flowing through the other thyristor and vice versa. In order not to make the gate pulses longer than necessary, they are cut off as soon as the respective anode current has reached a certain level. This level has to be above the thyristor latching current, thus allowing the anode current to continue flowing in absence of gate current.

It is an object of the present invention to detect the discontinuity in the output current of a thyristor configuration.

It is a further object of the present invention to eliminate thyristor rectifier output current oscillations or jumps due to the thyristor latching and holding current levels.

It is a further object of the present invention to eliminate heat losses caused by a thyristor rectifier being stressed by a reverse voltage while reverse thyristor current is flowing.

It is a further object of the present invention to eliminate an average negative generator field current coming from a thyristor rectifier in a Ward-Leonard electric drive when a large firing angle should lead to a small positive current.

It is a further object of the present invention to eliminate torque transients and vibration in an elevator drive.

It is a further object of the present invention to eliminate a jump of the generator field current from a negative value, the reverse current of a first thyristor rectifier current which itself provides a positive field current, to a positive value, the reverse current of a second thyristor rectifier which itself provides a negative field current, when the field current is supposed to smoothly change its direction from positive to negative.

These objects are solved according to the invention by a method for firing a thyristor in a thyristor rectifier according to claim 1 as well as by an apparatus for firing thyristors in a thyristor rectifier according to claim 2.

A method and apparatus for controlling a thyristor rectifier are disclosed comprising measuring the output current of the thvristor of said rectifier at or below a selected magnitude of said current and providing a discontinuity signal; and maintaining the gating current to said thyristor in said rectifier in response to said discontinuity signal.

The present invention provides a method for controlling a thyristor rectifier, the thyristors passing current in response to a firing angle signal which fires said thyristors at a given angle of supply voltage, comprising measuring the current through any of said thyristors in said rectifier at or below a selected magnitude and providing a discontinuity signal; inverting said discontinuity signal, thereby providing a thyristor gate enable signal in response to said firing angle signal and said discontinuity signal; providing a channeling signal, in response to said firing angle signal and said thyristor gate enable signal, for designating which of said thyristors in said rectifier will be gated on.

For controlling the current in an inductive load, the gate current used to fire thyristors in a rectifier is controlled to reach zero at exactly the same time, within a given half-wave, as the current in the inductive load which receives the voltage from the rectifier, keeping gate voltage on only so long as thyristor current is on. A discontinuous thyristor converter current signal is detected and used to generate an enable signal in conjunction with a thyristor gate voltage. The enable signal, in synchronism with a power supply line voltage, provides a pair of channeling signals which then, depending upon whether the field current is positive or negative, activate the gate voltages of the thyristors such that the gate voltages end exactly at that time, within a given half-wave, where the generator field current becomes discontinuous. The invention thus leads to a more ideal thyristor behavior in the region of small anode currents because the thyristors are enabled to carry small currents all the way down to zero without the thyristors switching off sooner than the time at which thyristor current is zero.

The problem and solution are stated differently. The firing angle ends at the end of the previous half-wave. If the gate voltage turns off before the thyristor has achieved its latching current, the thyristor will shut off so that no generator field current is produced which further causes negative effects on the drive. The solution is to lengthen the gate duty cycle. On the other hand, if the generator field current decreases below holding current and there is no gate current, then the thyristor shuts off suddenly, resulting in negative drive effects. The solution, then, is to continue gate current until thyristor current is zero, such that there is no sudden dropping off of thyristor current.

Second, when the thyristor current is zero, we have to turn off the gate current. When we have gate current and negative voltage across the thyristor, so that the thyristor will not be fired, there will be an undesirable reverse current through the thyristor. The solution is to have gate current on only when thyristor current is flowing.

In sum, we must ensure that the gate current is long enough to avoid the effects of latching and holding current, but short enough to avoid heat losses, or even a reverse current in the power converter should the thyristor be stressed by a reverse voltage. The problem is the jump in current when changing from the one power converter to the inverse connected one, in this two-way converter, in order to change field current direction. This should happen at zero current due to the largest possible firing angle at that event. This large firing angle, however, leads to a large average reverse current and the current jump will be as high as the sum of the reverse currents of each of the two one-way power converters that make up the two-way power converter. We enlarge the gate current into the negative half-wave to zero with the thyristor current and we cut off the gate current when thyristor current zeros.

Thus, the gate current must be enlarged into the negative half-wave and cannot be turned off at the end of the positive half-wave.

These and other objects, features and advantages of the invention will become more apparent in the light of the following description of an exemplary embodiment of the invention as shown in the accompanying drawing.

### Brief Description of the Drawing

Fig. 1 is a block diagram of a Ward-Leonard electric drive employing a thyristor configuration to excite a generator field winding.

Fig. 2 is a timing diagram of the input and output signals found in a prior art system.

Fig. 3 is a timing diagram of thyristor holding and latching currents, determined by the pulse width of the gating current and, determining generator field current.

Fig. 4 is a block diagram of the apparatus of the present invention.

Fig. 5 is a drawing of timing signals used in the apparatus of the present invention to cause thyristor gate current to shut off when the generator field current reaches zero.

Fig. 6 is a schematic diagram of the off-state monitor used in the present invention.

Fig. 7 is a detailed schematic diagram of portions of the block diagram of Fig. 4.

The solution of the problem is described by means of an example of a generator field current control of a Ward Leonard type drive in an elevator, but, in principle, it can be applied in each case where a discontinuous dc current through an inductive load is controlled by a thyristor rectifier.

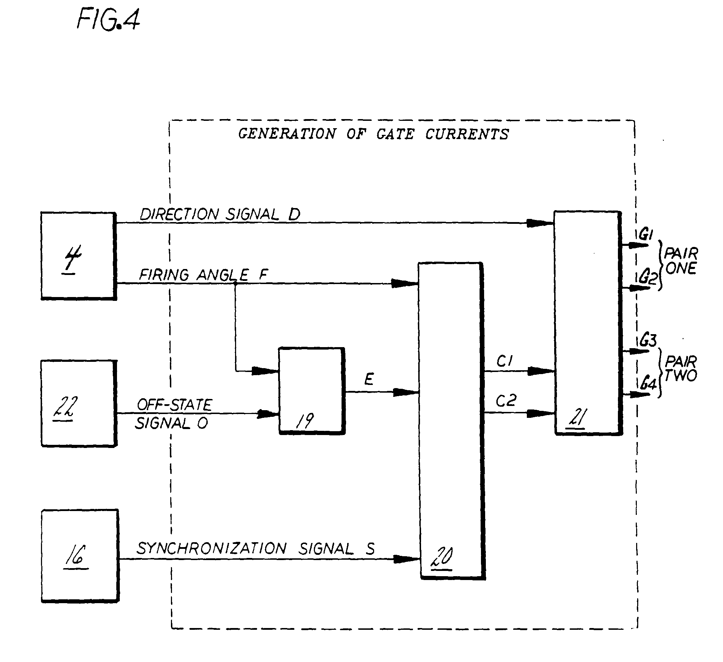

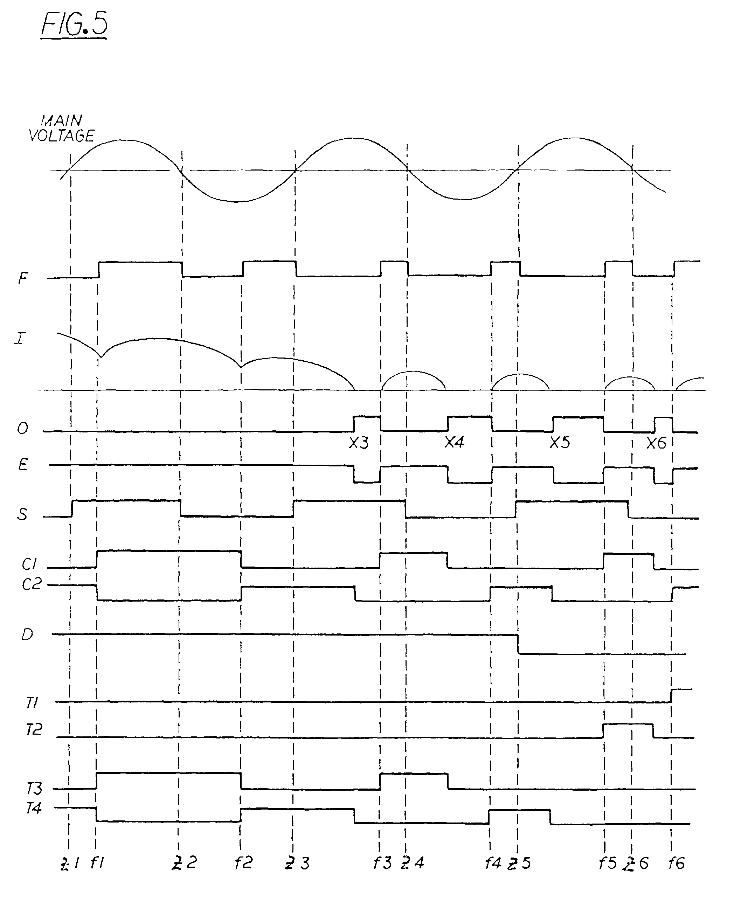

Fig. 4 shows the scheme of the generation of the thyristor firing current according to this invention. This process is divided into a firing command enable subprocess 19, a channeling subprocess 20, and a gating subprocess 21. Fig. 5 indicates the timing signals used and provided by each of these subprocesses.

As input signals to the process, the current regulator 4 delivers the current direction signal D and the SCR gate firing command F, the Off-State Monitor 22 delivers the Off-state signal O, and the Mains Monitor 16 delivers the Synchronization signal S, a square wave which is logic low in the negative half-wave and logic high in the positive half-wave. The state of the synchronization signal S changes at the zero crossings of the mains voltage. As outputs of the process, there are the four firing signals (G1,G2,G3,G4) for firing the four thyristors of Fig. 1. The direction signal D comes from the current regulator.

Corresponding to the firing angles at times fl to f6 of the regulator 7 a current Igf in the generator field flows. The current becomes temporarily discontinuous at times x3 to x6.

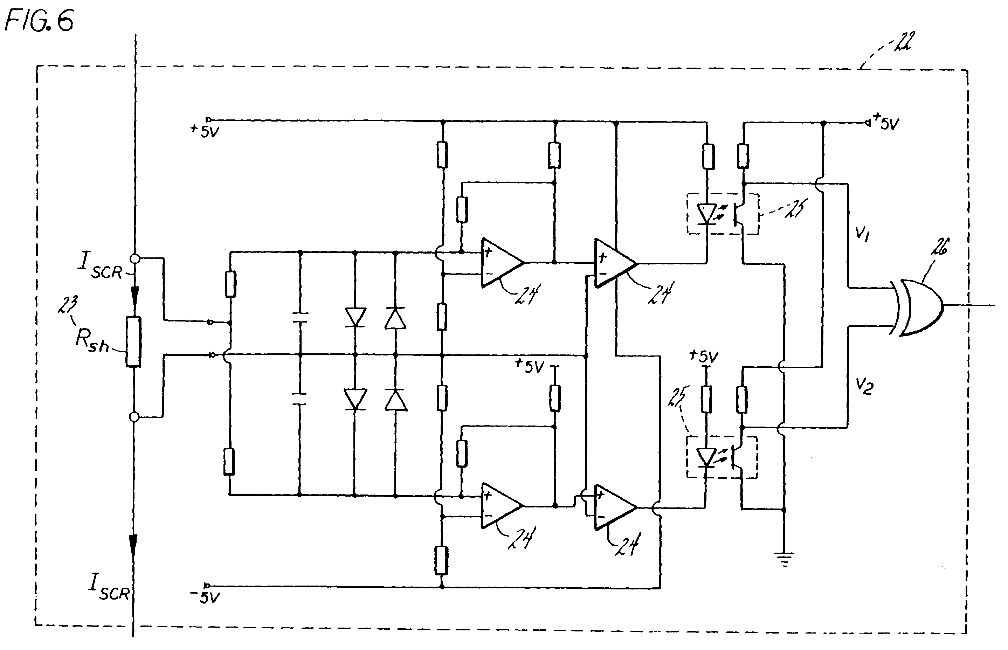

The Off-State Monitor 22 (Figs. 4 and 6) detects the discontinuity in the generator field current Igf and delivers the corresponding off-state signal O (Fig. 5). A shunt resistor 23 receives the current provided by the thyristor rectifier 6. The voltage of the shunt resistor is measured by the Off-State Monitor 22, giving the generator field current. The output signal O of the off-state monitor 22 is on logic level low if field current is flowing, while it is on logic level high while the current is zero. This signal is sent to a logic circuit 19 that has the task of shaping the thyristor firing current.

The on/off ratio, or duty cycle, of Iscr indicates the time duration of discontinuous current. The off-state monitor works as follows: The SCR converter current is measured by the shunt resistor Rsh 23 (Fig. 6), and the Iscr off-state is detected by four comparators 24 that change their output states depending on the shunt resistor voltage. Two logic signals V1 and V2 are sent to optically coupled isolators 25. While Iscr is flowing, V1 and V2 are equal. When Iscr is not flowing, Iscr discontinuity, V1 and V2, are not equal. V1 and V2 are then provided to a logical XOR 26, the output signal of which has the shape of a pulse width modulated signal. The XOR output signal O is logic level high if Iscr is not flowing and logic level low if Iscr is flowing.

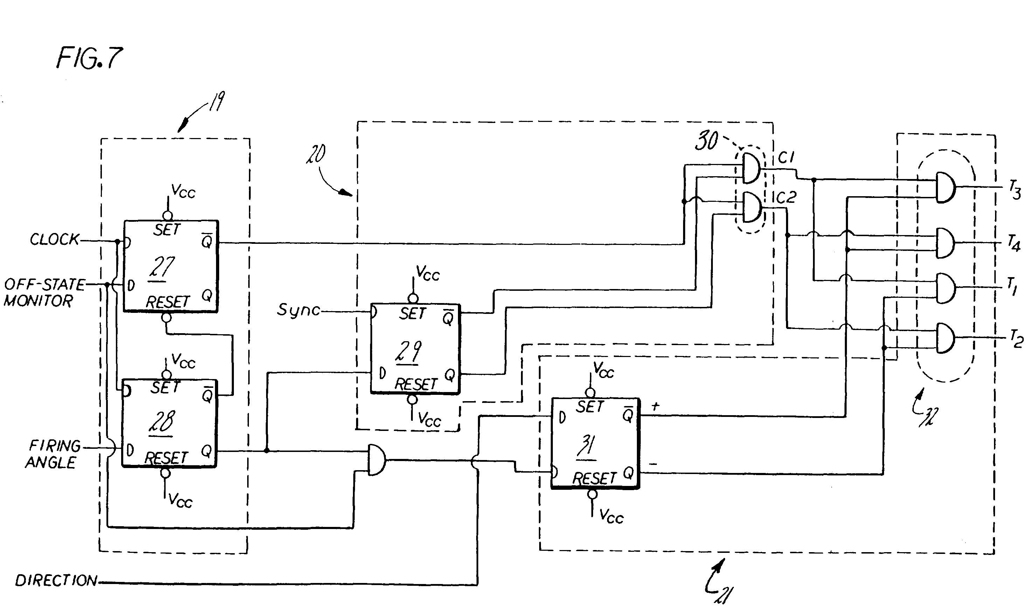

A firing command enable subprocess 19 is responsive to the firing command F, and the off-state signal O and provides a firing command enable E (Fig. 5). The firing command enable determines the time at which the gate current of any thyristor is allowed to flow. The firing command F then sets the firing command enable E independently of the off-state signal O to start the firing of the thyristors. If thyristor firing was only allowed while the field current is flowing, one would not be able at all to fire a thyristor at discontinuous current. So the enable signal E has to be set even if signal O is high, which is always the case for discontinuous current. Therefore, signal E is forced to logic high for the time period, during which the signal F is high (reset input of D flip-flop 27, Fig. 7) thus blocking the off-state monitor effect. Signal F becomes zero close to the end of each half-wave of the mains voltage, but current discontinuity can earliest appear at the beginning of the next half-wave.

The off-state signal O cuts off the firing command enable E as soon as the current in the generator field becomes zero so as to terminate the firing of the thyristors (Fig. 5). The firing command enable subprocess may be performed using two D flip-flops 27, 28 (Fig. 7). The off-state monitor output O is fed to a first flip-flop 27 and passed when the clock input is high. A second flip-flop 28 passes the firing angle command signal when the clock input is high. The complement output of flip-flop 28 resets the first flip-flop 27. The complement output of the first flip-flop is the firing enable command E (Figs. 5, 7).

The remaining steps in the process of this invention are needed to determine which thyristor to fire.

Subprocess 20 is responsive to the firing command enable E, the firing command F, and the synchronization signal S to form the two firing command channeling signals C1, C2 (Figs. 4, 5, 7). The firing command channeling signals determine which of the thyristors has to be fired with the new firing angle in the positive half-wave and which must be fired in the negative half-wave according to the mains voltage, Fig. 5. The firing command channeling subprocess 20 may be carried out by means of flip-flops and logical AND gates (Fig. 7). A third D flip-flop 29 is responsive to the synchronization signal S and the output of the flip-flop 28. The normal and complement outputs of the flip-flop 29 are provided to a pair of AND gates 30. An inverter could be substituted for the channeling flip-flop, but the preferred embodiment uses a flip-flop as it synchronizes the channeling signals with the mains voltage and eliminates propagation delays.

Finally, gating subprocess 21 is responsive to the firing command channeling signals C1,C2 and the direction signal D to form the four firing signals (G1,G2,G3,G4), one for each of the SCRs, T1, T2, T3 and T4, respectively. Direction signal D is logic high for positive generator field current and low for negative generator field current. The generator current is generally positive for positive direction of the elevator and vice versa, but it must change direction at the end of a deceleration (generating) phase, causing negative generator armature voltage and thus allowing the armature current to be maintained even at a low speed, when the motor armature voltage decreases to zero. The firing signals (G3,G4) will achieve a field current in the positive direction, whereas the signals (G1,G2) will achieve one in the negative direction. Thyristors T1 and T2 are not conducting at any time while D is high; thyristors T3 and T4 are conductive while D is low. When the direction of the generator field current is to be changed, the direction signal will toggle. To avoid a short circuit in the thyristor rectifier, the thyristor for the new current direction will be fired only after the current in the first direction becomes zero, as indicated by the off-state signal O on logic high level. Fig. 5 shows that any thyristor will be fired as long as current is flowing through it. In the case of discontinuous current the firing signal for one thyristor is cut off when the field current becomes zero. On the other hand, in the case of continuous current the firing signal is cut off when the next thyristor is to be fired. When the direction signal D changes (z5, Fig. 5) while one of the thyristors is on (in this case T4), the gate current must not be switched over to T1 (which is the respective thyristor for the other current direction) as long as T4 is on; T4 does not switch off by itself as long as its holding current remains exceeded. Otherwise, T1 and T4 would be on at the same time and would cause a short circuit of the transformer 10. So switching over of the gate current is only allowed during the off state of all thyristors which means zero generator field current detected by the off state monitor 22. T1 is not fired directly after time z5 although D changes to zero. The next thyristor to be fired after time x5 is T2.

A fourth D flip-flop 31 and four AND gates 32 are used for this purpose, the particular hardware used here being readily understood by those skilled in the art to be unimportant, and, of course, the invention could be implemented in software.

The firing signal F, obtained from the current regulator, and the off-state monitor output O are fed into the firing command enable subprocess 19. The firing command enable subprocess 19 provides that as long as there is current flowing in one of the thyristors, that is to say, while O is low, the firing enable signal is kept high. The firing enable signal goes high when a fire command F first issues from the regulator. E is kept high after F has been triggered and will be turned off when the current in one of the thyristors goes to zero. The firing command enable signal will again be set high the next time a fire command is issued from the current regulator. It will again turn off when the gate current goes zero. The firing enable signal E does not command the firing of the thyristors but only commands that some thyristor should be fired. Here, the firing angle is clocked into a D flip-flop 28 while the off-state monitor signal O is clocked into a D flip-flop 27.

## Claims

1. A method for firing a thyristor (T1-T4) in a thyristor rectifier (6), the thyristors (T1-T4) passing current in response to a firing angle signal (G) which fires said thyristors (T1-T4) at a given angle of supply voltage, comprising the step:
a) measuring the current through any of said thyristors (T1-T4) in said rectifier (6) at or below a selected non-negative magnitude and providing a discontinuity signal (O);
characterized by further steps:
b) in response to said firing angle signal (G) and said discontinuity signal (O), inverting said discontinuity signal (0), thereby providing a thyristor gate enable signal (E); and
c) providing a channeling signal (C), in response to said firing angle signal (G) and said thyristor gate enable signal (E), for designating which of said thyristors (T1-T4) in said rectifier will be gated on.

2. An apparatus for firing thyristors (T1-T4) in a thyristor rectifier (6), said thyristors (T1-T4) being gated on by a firing angle signal (G) at a predetermined angle of the supply voltage, comprising:
a) means (22) for detecting the current through any of the thyristors (T1-T4) in said rectifier reaching a value at or below a selected non-negative magnitude and providing a discontinuity signal (O);
characterized by
b) inverting means (19), responsive to said discontinuity signal (O) and said firing angle signal (E), for providing an inverted discontinuity signal;
c) means (30) for providing a channeling signal (C), responsive to said discontinuity signal (O) and said firing angle signal (G), for designating which of the thyristors (T1-T4) of said rectifier (6) will be fired.

## Patentansprüche

1. Verfahren zum Zünden eines Thyristors (T1-T4) in einem thyristorbestückten Gleichrichter (6), wobei die Thyristoren (T1-T4) Strom abhängig von einem Zündwinkelsignal (G) durchlassen, welches die Thyristoren (T1-T4) bei einem gegebenen Winkel einer Versorgungsspannung zündet, umfassend den Schritt:
a) Messen des durch irgendeinen der Thyristoren (T1-T4) in dem Gleichrichter (6) fließenden Stroms bei oder unterhalb eines ausgewählten, nicht-negativen Betrags und Bereitstellen eines Diskontinuitätssignals (O);
**gekennzeichnet durch** die weiteren Schritte:
b) ansprechend auf das Zündwinkelsignal (G) und das Diskontinuitätssignal (O), Invertieren des Diskontinuitätssignals (0), um dadurch ein Thyristorgate-Freigabesignal (E) zu liefern; und
c) Bereitstellen eines Kanalisiersignals (C) ansprechend auf das Zündwinkelsignal (G) und das Thyristorgate-Freigabesignal (E), um festzulegen, bei welchem der Thyristoren (T1-T4) in dem Gleichrichter das Gate eingeschaltet wird.

2. Vorrichtung zum Zünden von Thyristoren (T1-T4) in einem thyristorbestückten Gleichrichter (6), wobei die Gates der Thyristoren (T1-T4) durch ein Zündwinkelsignal (G) bei einem vorbestimmten Winkel der Versorgungsspannung eingeschaltet werden, umfassend:
a) eine Einrichtung (22) zum Nachweisen, daß der Strom durch irgendeinen der Thyristoren (T1-T4) in dem Gleichrichter einen Wert bei oder unterhalb eines ausgewählten nicht-negativen Betrags erreicht, um ein Diskontinuitätssignal (O) bereitzustellen,
**gekennzeichnet durch**
b) eine Invertiereinrichtung (19), die ansprechend auf das Diskontinuitätssignal (O) und das Zündwinkelsignal (E) ein invertiertes Diskontinuitätssignal liefert;
c) eine Einrichtung (30) zum Bereitstellen eines Kanalisiersignals (C) ansprechend auf das Diskontinuitätssignal (O) und das Zündwinkelsignal (G), um festzulegen, welcher der Thyristoren (T1-T4) des Gleichrichters (6) gezündet wird.

## Revendications

1. Procédé d'amorçage d'un thyristor (T1-T4) dans un redresseur (6) à thyristors, les thyristors (T1-T4) laissant passer un courant en réponse à un signal d'angle d'amorçage (G) qui amorce lesdits thyristors (T1-T4) pour un angle donné de la tension d'alimentation, comprenant l'étape qui consiste :
a) à mesurer le courant traversant l'un quelconque desdits thyristors (T1-T4) dudit redresseur (6) à ou au-dessous d'une amplitude non négative sélectionnée et à fournir un signal de discontinuité (O) ;
caractérisé en ce qu'il comprend en outre les autres étapes qui consistent :
b) en réponse audit signal d'angle d'amorçage (G) et audit signal de discontinuité (O), à inverser ledit signal de discontinuité (O), en appliquant ainsi à la gâchette du thyristor un signal de validation (E) ; et
c) à fournir un signal de distinction de canal (C) en réponse audit signal d'angle d'amorçage (G) et audit signal de validation de gâchette de thyristor (E) pour désigner celui desdits thyristors (T1-T4) dudit redresseur qui doit être rendu passant.

2. Dispositif pour amorcer des thyristors (T1-T4) dans un redresseur (6) à thyristors, lesdits thyristors (T1-T4) étant amenés à l'état passant par un signal d'angle d'amorçage (G) pour un angle prédéterminé de la tension d'alimentation, comprenant :
a) des moyens (22) pour détecter le courant circulant dans l'un quelconque des thyristors (T1-T4) dudit redresseur qui atteint une valeur égale ou inférieure à une amplitude non négative sélectionnée et pour fournir un signal de discontinuité (O) ;
caractérisé par
b) un moyen d'inversion (19) répondant audit signal de discontinuité (O) et audit signal d'angle d'amorçage (E) pour fournir un signal de discontinuité inversé ;
c) un moyen (30) pour fournir un signal de distinction de canal (C) qui répond audit signal de discontinuité (O) et audit signal d'angle d'amorçage (G) pour désigner lequel des thyristors (T1-T4) dudit redresseur (6) sera amorcé.
